**Europäisches Patentamt**

**European Patent Office**

**Office européen des brevets**

(19)

(11) Numéro de publication : **0 284 485 B1**

(12)

# FASCICULE DE BREVET EUROPEEN

(45) Date de publication du fascicule du brevet :
**04.12.91 Bulletin 91/49**

(51) Int. Cl.⁵ : **H03B 9/14**

(21) Numéro de dépôt : **88400581.0**

(22) Date de dépôt : **11.03.88**

(54) Oscillateur hyperfréquence intégré dans un guide d'ondes.

(30) Priorité : **19.03.87 FR 8703837**

(43) Date de publication de la demande :
**28.09.88 Bulletin 88/39**

(45) Mention de la délivrance du brevet :
**04.12.91 Bulletin 91/49**

(84) Etats contractants désignés :
**DE GB NL**

(56) Documents cités :
**EP-A- 0 005 096**
**EP-A- 0 068 946**
**US-A- 4 588 967**
**WESCON TECHNICAL PAPERS, vol. 20, no. 20, 1976, pages 1-8, North Hollywood, US; K.P. WELLER: "Solid state millimeter wave sources"**

(56) Documents cités :
**IEEE TRANSACTIONS ON MICROWAVE THEORY AND TECHNIQUES, vol. 24, no. 10, octobre 1976, pages 650-656, New York, US; K.M. JOHNSON: "Posttuning drift of a transferred-electron-device voltage-controlled oscillator"**

(73) Titulaire : **THOMSON HYBRIDES ET MICROONDES**
**173, bld Haussmann**
**F-75008 Paris (FR)**

(72) Inventeur : **Stevance Jean**
**THOMSON-CSF SCPI 19, avenue de Messine**
**F-75008 Paris (FR)**
Inventeur : **Klein, Edmond**
**THOMSON-CSF SCPI 19, avenue de Messine**
**F-75008 Paris (FR)**
Inventeur : **Lleti, Georges**
**THOMSON-CSF SCPI 19, avenue de Messine**
**F-75008 Paris (FR)**

(74) Mandataire : **Taboureau, James et al**
**THOMSON-CSF SCPI**
**F-92045 Paris La Défense Cédex 67 (FR)**

## Description

La présente invention concerne un oscillateur hyperfréquence à diode, accordable par une tension et intégré dans un guide d'ondes. Cet oscillateur, qui comprend un varactor intégré lui aussi dans le guide d'ondes, travaille dans la bande W aux environs de 94 GHz : la présence du varactor permet de régler facilement la fréquence de l'oscillateur et également de le moduler en fréquence.

Les oscillateurs hyperfréquences, à transistor ou à diode, sont bien connus voir par exemple la demande EP-A 0068946 et de façon générale on cherche plutôt à les stabiliser, par exemple par un résonateur diélectrique, de façon à pouvoir les monter en association et disposer ainsi d'une puissance accrue. Mais avec les progrès accomplis dans ce domaine des hyperfréquences comprises entre quelques GHz et 100 GHz, on envisage maintenant de pouvoir échanger des informations par modulation de fréquence, plus particulièrement dans la fenêtre de 94 GHz puisqu'on sait que l'atmosphère est transparente dans cette gamme de fréquence. Il s'agit de transposer aux environs de 94 GHz ce que l'on sait faire en radio fréquence aux environs de 100 MHz.

L'oscillateur selon l'invention comprend un guide d'ondes métallique, de section interne 2,54 × 1,27 mm, à l'intérieur duquel est positionnée une diode à résistance négative. Cette diode est encapsulée dans un boitier fermé par un couvercle métallique dit "cap". Sur le cap est fixée une capacité de couplage, et sur l'armature libre de cette capacité est soudée l'une des deux connexions d'un varactor monté en beam-lead. L'autre connexion du varactor est soudée sur un pion métallique, à la masse. Deux fils métalliques amènent, à travers les parois du guide d'ondes, les deux tensions de polarisation de la diode et du varicap.

De façon plus précise, l'invention concerne un oscillateur hyperfréquence intégré dans un guide d'ondes, comportant une diode à résistance négative, accordée en fréquence par un varactor, caractérisé en ce que :

— la diode, encapsulée dans un boîtier à cap, est montée sur une embase métallique, et affleure au niveau d'une paroi du guide d'ondes,

— une capacité de couplage est fixée par l'une de ses électrodes sur le cap métallique du boîtier,

— le varactor, encapsulé en boîtier à poutres (beam-leads), est monté en pont entre l'électrode libre d'accès de la capacité et un pion métallique fixé sur l'embase et à la masse,

— la polarisation de la diode étant amenée par un fil métallique soudé sur le cap

— et la polarisation du varactor étant amenée par un fil métallique soudé sur l'électrode libre d'accès de la capacité de couplage.

L'invention sera mieux comprise par la description suivante d'un exemple de réalisation de l'oscillateur, cette description s'appuyant sur les figures jointes en annexe qui représentent :

— figure 1 : schéma électrique de l'oscillateur hyperfréquence commandé par une tension, selon l'invention

— figure 2 : vue en coupe de l'oscillateur selon l'invention, intégré dans un guide d'ondes

— figure 3 : vue en plan de l'oscillateur selon l'invention, correspondant à la vue en coupe de la figure 2.

— figures 4 et 5 : courbes de variation de la puissance et de la fréquence, en fonction de la tension appliquée sur le varactor, pour deux oscillateurs réalisés conformément à l'invention.

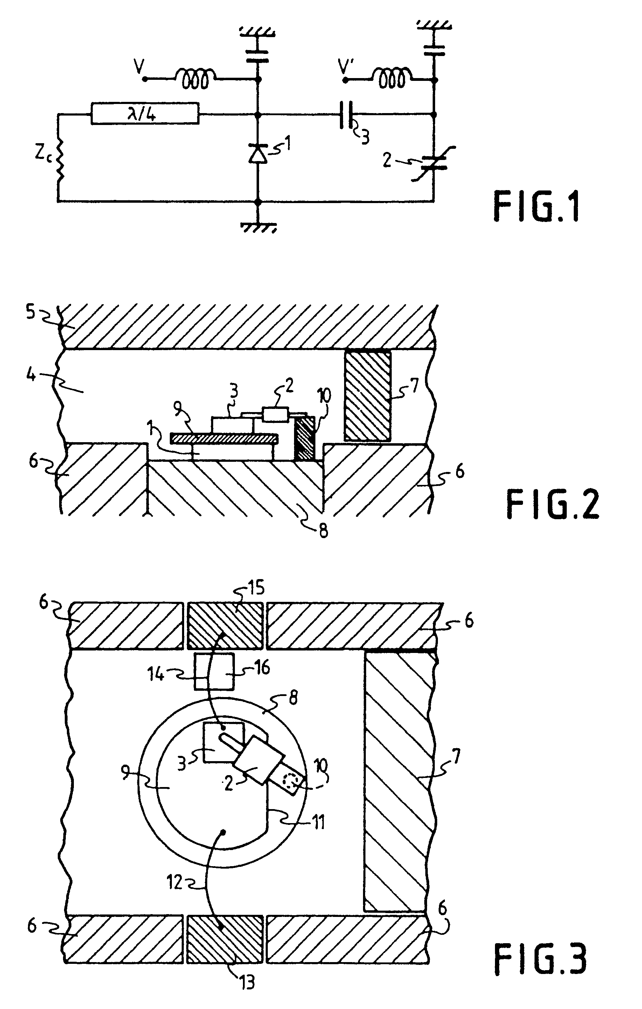

La figure 1 donne le schéma électrique de l'oscillateur commandé par une tension, selon l'invention, ce type d'oscillateur étant fréquemment désigné sous le sigle VCO, c'est à dire en anglais "Voltage Controlled Oscillator". Le circuit comprend une diode 1 à résistance négative, de type diode à avalanche, Gunn, IMPATT... Il comprend également un varactor 2 couplé à la diode 1 par une capacité de couplage 3. La diode 1 est polarisée par une tension V, appliquée par l'intermédiaire d'un circuit qui comprend une partie selfique, et qui est découplée à la masse par une capacité, comme cela est couramment pratiqué. Le varactor est également polarisé par une tension V', fournie par un circuit qui comprend également une partie selfique et est découplé à la masse par une capacité.

En fait, la diode 1 est montée dans un boîtier qui est représenté en coupe sur la figure 2, ce boîtier comportant un couvercle dit cap, dont le diamètre est ajusté pour ramener sur la diode à avalanche une impédance $Z_c$ telle que les conditions de démarrage des oscillations soient satisfaites. Sur la figure 1 la ligne $\lambda/4$ figure le cap du boitier d'encapsulation de la diode, et $Z_c$ figure l'impédance de rayonnement du cap.

En faisant varier la capacité du varactor 2 commandé par la tension de polarisation V', on fait varier la capacité montée en parallèle sur la diode 1, ce qui permet de régler facilement la fréquence d'émission de l'oscillateur, ou de le moduler en fréquence.

La figure 2 représente une vue en coupe de cet oscillateur tel qu'il est intégré à l'intérieur d'un guide d'ondes. Le guide d'ondes est composé de deux blocs métalliques 5 et 6 rainurés pour créer un guide d'ondes dont une cavité 4, qui, aux fréquences considérées, mesure intérieurement 2,54 mm de largeur et 1,27 mm de hauteur. Cette cavité est fermée d'un côté par un piston de court-circuit 7, dont la position réglable permet d'ajuster l'oscillation à l'intérieur de la cavité 4. Dans l'un des deux blocs qui composent le guide d'ondes, le

2

bloc 6 par exemple, est percé un orifice à travers lequel passe un support métallique 8, fileté de façon à pouvoir régler en hauteur la position de la diode.

Sur la face libre et plane du support métallique 8 est fixée la diode 1, dont on ne voit, sur la figure 2, que l'anneau de diéléctrique qui forme le boîtier, refermé par un disque métallique 9, dit cap. Ce disque a un diamètre plus grand que l'anneau de diélectrique dans le but de ramener sur la diode une impédance déterminée. Sur ce disque métallique est fixée par l'intermédiaire de l'une de ces électrodes, une capacité 3 qui est la capacité de découplage entre la diode 1 et le varactor 2.

Par ailleurs, à côté du boîtier d'encapsulation de la diode, un pion métallique 10 est fixé sur le support 8, et ce pion métallique se trouve donc à la masse. La hauteur du pion métallique 10 est équivalente à la hauteur totale du boîtier d'encapsulation de la diode plus la capacité 3, ce qui permet de souder un varactor 2, en boîtier beam-lead, c'est à dire ayant ses connexions d'accès extérieures prises par des poutres, en pont entre la capacité 3 et le pion métallique 10.

La structure de cet oscillateur à l'intérieur du guide d'ondes, ainsi que le système de polarisation ressort mieux de la figure 3, qui reprend l'objet de la figure 2 selon un plan sensiblement au niveau du cap de la diode. On voit donc sur la figure 3 que le cap 9 est légèrement recoupé en 11 à l'extérieur du boîtier d'encapsulation de la diode 1, de façon à permettre la fixation du pion de mise à la masse. En fait, recouper le cap 9 n'est pas indispensable, et l'opération peut être menée de la même façon si l'embase 8 a un diamètre suffisamment grand pour le permettre.

Tandis que dans l'art connu, la diode oscillatrice est très généralement polarisée au moyen d'une antenne métallique qui descend perpendiculairement par rapport au cap 9, dans l'oscillateur selon l'invention les connexions de polarisation de la diode et du varicap viennent dans un plan parallèle à celui du cap 9 et traversent les parois latérales du guide d'ondes. Ainsi la diode oscillatrice est polarisée par l'intermédiaire d'un fil ou d'un ruban métallique 12 dont une extrémité est soudée sur le cap 9 et dont l'autre extrémité est soudée sur une capacité de découplage 13, qui fait office de bouchon de l'orifice pratiqué dans la paroi 6 du guide d'ondes. De la même façon le varactor 2 est polarisé au moyen d'un fil ou d'un ruban métallique 14 soudé par une extrémité sur la face supérieure de la capacité de découplage 3 et par une autre extrémité sur une capacité de découplage 15 qui obture l'orifice pratique dans une autre paroi du guide d'ondes. Les orifices perforés à travers les deux parois opposées du guide d'ondes sont des orifices rectangulaires de dimension 1 × 0,36 mm, formant un guide sous coupure pour les fréquences du fonctionnement du VCO. Il a été dit que cet oscillateur fonctionne aux environs de 94 GHz, et un canal ayant une dimension de 1 mm coupe les fréquences inférieures à 150 GHz : par conséquent les deux canaux rectangulaires coupent les fréquences du VCO, d'autant plus qu'ils sont obturés partiellement soit par les capacités de découplage 13 et 15, soit par des lignes métalliques gravées sur des substrats diélectriques qui obturent ces mêmes canaux.

La position de l'oscillateur dans le guide d'ondes est optimisée s'il est orienté tel que représenté sur les figures 2 et 3, c'est à dire que les éléments tels que le varactor 2, la capacité de couplage 3, le pion métallique 10 et la face 11 du cap 9 sont préférentiellement disposés du côté du piston 7, et que par conséquent la face du boîtier de l'oscillateur qui est tournée vers la charge active du guide d'ondes ne présente pas de modification par rapport aux oscillateurs connus, dans lesquels le varactor n'est pas introduit dans le guide d'ondes.

En ce qui concerne les fils ou rubans de connexion 12 et 14, la connexion du côté du varator, c'est à dire la connexion 14, doit être bien étudiée de façon à éviter les résonances parasites : dans les montages qui ont été réalisés, il a été trouvé qu'un morceau de matériau diélectrique 16 tel que l'Eccosorb placé sous le fil 14, entre le fil 14 et la paroi de guide d'ondes, permet d'éliminer l'harmonique 2 du signal, qui perturbe profondément le fonctionnement du VCO.

Pour la réalisation de l'oscillateur commandé en tension, on a utilisé des diodes à avalanche au silicium, de moyenne puissance (200 mW). Les varactors sont des varactors à jonction $P^+N$ réalisés en structure beam-lead, dont les principales caractéristiques sont les suivantes :

Tension de claquage $\quad : \quad V_{BD} \quad \geqslant 20$ volts

Capacité de jonction à $0^V \quad : \quad C_{jo} = 0,1$ à $0,15$ pf

Rapport de capacité de jonction : $\dfrac{C_{j\,max}}{C_{j\,min}} \gg 3$

Fréquence de coupure à $-4$ volts mesurée à une fréquence supérieure ou égale à 30 GHz : $f_{C-4} \quad \geqslant 1000$ GHz

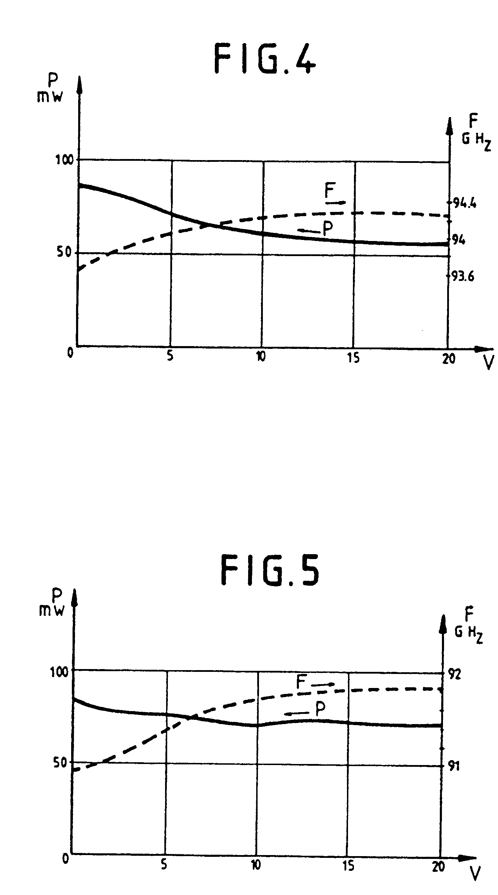

Les figures 4 et 5 donnent des courbes de variation de la puissance et de la fréquence, en fonction de la tension appliquée sur le varactor pour deux oscillateurs choisis parmi ceux qui ont été réalisés. Les différences qui apparaissent dans les résultats de ces deux oscillateurs correspondent seulement aux différences inhérentes à la réalisation des semiconducteurs et de cavités hyperfréquences aussi petites, et de réglage aussi délicat.

De façon plus précise, ces deux oscillateurs ont donné les résultants ci-dessous :

### Fig. 4

| | | | |
|---|---|---|---|
| Puissance max | $(V_{varactor} = 0)$ | 87 | mW |
| Puissance min | $(V_{varactor} = 20$ volts$)$ | 56 | mW |
| $\triangle P$ | | 1,91 | db |
| Fréquence min | $(V_\nu = 0)$ | 93,6 | GHz |
| Fréquence max | $(V_\nu = 20^V)$ | 94,3 | GHz |
| $\triangle f$ | | 700 | MHz |

### Fig. 5

| | | | |
|---|---|---|---|
| Puissance max | $(V_\nu = 0)$ | 84 | mW |
| Puissance min | $(V_\nu = 20^V)$ | 74 | mW |
| $\triangle P$ | | 0,55 | db |
| Fréquence min | $(V_\nu = 0)$ | 90,9 | GHz |
| Fréquence max | $(V_\nu = 20^V)$ | 91,85 | GHz |
| $\triangle f$ | | 950 | MHz |

On voit que l'oscillateur selon l'invention a une bande d'accord qui peut atteindre 1 GHz, pour une fréquence centrale de l'ordre de 94 GHz. Cette propriété est intéressante dans les émetteurs modulés en fréquence, ou comme oscillateur local d'un récepteur hyperfréquence. L'oscillateur hyperfréquence selon l'invention est précisé par les revendications suivantes.

## Revendications

1. Oscillateur hyperfréquence intégré dans un guide d'ondes, comportant une diode (1) à résistance négative, accordée en fréquence par un varactor (2), caractérisé en ce que :

— la diode (1), encapsulée dans un boîtier à cap (9), est montée sur une embase métallique (8), et affleure au niveau d'une paroi (6) du guide d'ondes,

— une capacité de couplage (3) est fixée par l'une de ses électrodes sur le cap métallique (9) du boîtier,

— le varactor (2), encapsulé en boîtier à poutres (beam-leads) est monté en pont entre l'électrode libre d'accès de la capacité (3) et un pion métallique (10) fixé sur l'embase (8) et à la masse,

— la polarisation de la diode (1) étant amenée par un fil métallique (12) soudé sur le cap (9)

— et la polarisation du varactor (2) étant amenée par un fil métallique (14) soudé sur l'électrode libre d'accès de la capacité de couplage (3).

2. Oscillateur hyperfréquence selon la revendication 1, caractérisé en ce que, le guide d'ondes étant fermé d'un côté par un piston (7) de court-circuit, le pion (10) de fixation du varactor (2) est situé entre la diode (1) et le piston (7) de court-circuit.

3. Oscillateur hyperfréquence selon la revendication 2, caractérisé en ce que, le cap (9) de fermeture du microboîtier de la diode est découpé du côté (11) où le pion (10) de mise à la masse est fixé sur l'embase (8).

4. Oscillateur hyperfréquence selon la revendication 1, caractérisé en ce que, pour la diode (1) et pour le varactor (2), les tensions de polarisations sont amenées dans le plan du guide d'ondes, à travers deux orifices percés dans deux parois latérales (6) du guide, ces orifices ayant des dimensions sous coupure par rapport à la fréquence de travail de l'oscillateur.

5. Oscillateur hyperfréquence selon la revendication 4, caractérisé en ce que la traversée des parois latérales (6) du guide d'ondes se fait au moyen d'une capacité (13, 15) ou d'un filtre en microbandes sur substrat, et en ce que cette capacité obture l'orifice dans la paroi (6).

6. Oscillateur hyperfréquence selon la revendication 4, caractérisé en ce qu'un petit volume de matériau absorbant (16), placé entre le guide d'ondes et le fil (14) de polarisation du varactor (2), élimine l'harmonique 2 de la fréquence de fonctionnement de l'oscillateur.

## Patentansprüche

1. Ultrahochfrequenz-Oszillator, der in einen Wellenleiter integriert ist und eine Diode (1) mit negativem Widerstand, deren Frequenz mittels einer Reaktanzdiode (2) abgestimmt wird, aufweist, dadurch gekennzeichnet, daß

— die Diode (1), die in einem Behälter mit Deckel (9) eingekapselt ist, auf einer metallischen Befestigungsplatte (8) angebracht ist und mit dem Niveau einer Wand (6) des Wellenleiters bündig ausgerichtet ist,

— eine Kopplungskapazität (3) mit einer ihrer Elektroden am metallischen Deckel (9) des Gehäuses befestigt ist,

— die Reaktanzdiode (2), die in ein Gehäuse mit Stegen(Beam-Leads) eingekapselt ist, als Brücke zwischen der freien Zugriffselektrode der Kapazität (3) und einem an der Befestigungsplatte (8) und der Masse befestigten Metallstück (10) angebracht ist,

— die Polarisation der Diode (1) mittels eines auf den Deckel (9) gelöteten Metalldrahtes (12) erzeugt wird

— und die Polarisation der Reaktanzdiode (2) mittels eines auf die freie Zugriffselektrode der Kopplungskapazität (3) gelöteten Metalldrahts (14) erzeugt wird.

2. Ultrahochfrequenz-Oszillator gemäß Anspruch 1, dadurch gekennzeichnet, daß bei einem auf einer Seite mittels eines Kolbenabschwächers (7) verschlossenen Wellenleiter das Metallstück (10) zur Befestigung der Reaktanzdiode (2) zwischen der Diode (1) und dem Kolbenabschwächer (7) angeordnet ist.

3. Ultrahochfrequenz-Oszillator gemäß Anspruch 2, dadurch gekennzeichnet, daß der Verschlußdeckel (9) des Mikrogehäuses der Diode auf der Seite (11), an der das Erdungs-Metallstück (10) an der Befestigungsplatte (8) befestigt ist, abgeschnitten ist.

4. Ultrahochfrequenz-Oszillator gemäß Anspruch 1, dadurch gekennzeichnet, daß für die Diode (1) und für die Reaktanzdiode (2) die Polarisationsspannungen in der Ebene des Wellenleiters durch zwei in zwei Seitenwände (6) des Leiters ausgebildete Öffnungen zugeführt werden, wobei diese Öffnungen Abmessungen unterhalb der Kappungsgrenze in bezug auf die Arbeitsfrequenz des Oszillators besitzen.

5. Ultrahochfrequenz-Oszillator gemäß Anspruch 4, dadurch gekennzeichnet, daß die Durchsetzung der Seitenwände (6) des Wellenleiters mittels einer Kapazität (13, 15) oder eines Mikrostreifenfilters auf einem Substrat bewerkstelligt wird und daß diese Kapazität die Öffnung in der Wand (6) verschließt.

6. Ultrahochfrequenz-Oszillator gemäß Anspruch 4, dadurch gekennzeichnet, daß ein kleines Volumen eines absorbierenden Materials (16), das zwischen den Wellenleiter und den Draht (14) für die Polarisation der Reaktanzdiode (2) gesetzt ist, die 2. Harmonische der Betriebsfrequenz des Oszillators beseitigt.

**Claims**

1. A microwave oscillator integrated in a wave guide, comprising a diode (1) with a negative resistance and frequency-tuned by a varactor (2), characterized in that
   — the diode (1), encapsulated in a casing with a cap (9), is mounted on a metal seat (8) and runs flush with the level of a wall (6) of the wave guide,
   — a coupling capacitor (3) is secured by one of its electrodes on the metal cap (9) of the casing,
   — the varactor (2) which is encapsulated in a beam lead casing, is mounted as a bridge between the free access electrode of the capacitor (3) and a metal blob (10) secured to the seat (8) and ground,
   — the polarization of the diode (1) being produced by a metal wire (12) soldered on the cap (9),
   — and the polarization of the varactor (2) being produced by a metal wire (14) soldered on the free access electrode of the coupling capacitor (3).

2. The microwave oscillator as claimed in claim 1, characterized in that, the wave guide being shut off on one side by a short circuit piston (7), the securing blob (10) of the varactor (2) is positioned between the diode (1) and the short circuit piston (7).

3. The microwave oscillator as claimed in claim 2, characterized in that the cap (9) of the microcasing of the diode is cut on the side (11) where the grounding blob (10) is secured to the seat (8).

4. The microwave oscillator as claimed in claim 1, characterized in that for the diode (1) and for the varactor (2) the polarization voltages are introduced in the plane of the wave guide through two orifices produced in the two lateral walls (6) of the guide, said two orifices having dimensions below cut-off in relation to the working frequency of the oscillator.

5. The microwave oscillator as claimed in claim 4, characterized in that the passage through the lateral walls (6) of the wave guide is by means of a capacitor (13 and 15) or of a microstrip filter using a substrate and in that said capacitor shuts off the opening in the wall (6).

6. The microwave oscillator as claimed in claim 4, characterized in that a small volume of the absorbing material (16), positioned between the wave guide and the wave (14) for the polarization of the varactor (2), eliminates the second harmonic of the frequency of operation of the oscillator.

FIG.1

FIG.2

FIG.3

# FIG.4

# FIG.5